# EUROPÄISCHE PATENTSCHRIFT

(11) **EP 1 715 075 B1**
(45) Veröffentlichungstag und Bekanntmachung des Hinweises auf die Patenterteilung: **16.04.2008**
(21) Anmeldenummer: 05008662.8
(22) Anmeldetag: 20.04.2005
(51) Int. Cl.: C23C 14/04

(54) **Magnetische Maskenhalterung**
Magnetic mask holder
Support de masque magnétique

(43) Veröffentlichungstag der Anmeldung: 25.10.2006
(73) Patentinhaber: Applied Materials GmbH & Co. KG, 63755 Alzenau (DE)
(72) Erfinder: Manz, Dieter, 72141 Walddorfhäslach (DE)
(74) Vertreter: Lang, Christian

(56) Entgegenhaltungen:
- PATENT ABSTRACTS OF JAPAN Bd. 1998, Nr. 11, 30. September 1998 (1998-09-30) -& JP 10 152776 A (TORAY IND INC), 9. Juni 1998 (1998-06-09)
- PATENT ABSTRACTS OF JAPAN Bd. 2003, Nr. 12, 5. Dezember 2003 (2003-12-05) -& JP 2004 047238 A (ANS INC), 12. Februar 2004 (2004-02-12)

## Beschreibung

Die vorliegende Erfindung betrifft eine Maskenhalterung für insbesondere großflächige Substrate, insbesondere zur Mikrostrukturierung von organischen elektrolumineszierenden Materialien (OLED) auf vorzugsweise großflächigen Substraten, insbesondere Bildschirmen, Displays und dergleichen mittels Vakuumbeschichtungsverfahren.

Bei der Herstellung von so genannten OLED-Displays oder -Bildschirmen, die die Licht emittierenden Eigenschaften von organischen, elektrolumineszierenden Materialien (OLED) nutzen, ist es erforderlich, die organischen elektrolumineszierenden Materialien mit einer entsprechenden Mikrostrukturierung auf einem transparenten Substrat, wie beispielsweise Glas aufzubringen, so dass über entsprechende Elektrodenschichten die elektrolumineszierenden Strukturen angesteuert und zur Lichtabgabe angeregt werden können.

Die Aufbringung der mikrostrukturierten, organischen, elektrolumineszierenden Materialien erfolgt üblicherweise durch Vakuumbeschichtungsprozesse, wobei zur Erzeugung der Mikrostruktur entsprechende Schattenmasken eingesetzt werden. Diese Maske müssen in geeigneter Weise auf die Substrate aufgesetzt, mit diesen durch die entsprechenden Beschichtungskammern transportiert und dann von den Substraten wieder abgenommen werden, um nach einer eventuellen Reinigung wieder erneut eingesetzt zu werden.

Aus der Stand der Technik sind magnetischen Maskenhaltervorrichtungen bekannt (JP2004-47238 und JP10-152776).

Aufgrund der geringen Dimensionen der Mikrostrukturierung kommt es hierbei auf eine sehr genaue Positionierung der Masken an, insbesondere wenn so genannte RGB-Displays hergestellt werden, bei denen für die bunte Darstellung auf dem Display eng benachbart zueinander Pixelbereiche für rotes, grünes und blaues Licht erzeugt werde müssen. Darüber hinaus erfordern die Vakuumbeschichtungsprozesse einen hohen Grad an Reinheit, so dass durch die Handhabungseinrichtungen für die Masken gewährleistet sein muss, dass keine unnötigen Partikel erzeugt werden.

Aus dem Stand der Technik ist eine Magnethalterung für Folienmasken bekannt (DE 297 07 686 U1), bei der auf einem Substratträger über Fixierstifte eine Folienmaske angeordnet wird, auf der dann wiederum das zu beschichtende Substrat zu liegen kommt. Über dem Substrat wird dann eine Magnetanordnung vorgesehen, die dazu dient, die ferromagnetische Maske vollflächig gegen das Substrat zu drücken, das zwischen Maske und Magnetanordnung vorgesehen ist. Bei einer derartigen Ausgestaltung einer Maskenhalterung wird durch die mechanische Befestigung der Maske auf dem Substratträger die Erzeugung von unerwünschten Partikeln begünstigt und zudem ist eine derartige Anordnung ungünstig für eine einfache, schnelle und präzise Anordnung und Entfernung der Maske von dem Substrat.

Ferner ist aus der EP 1 202 329 A2 eine Maskenanordnung bekannt, bei der eine Maske durch eine hinter dem Substratträger angeordneten Magnetanordnung vollflächig gegen das Substrat gedrückt wird. Die dort beschriebenen Masken können einen umlaufenden Rahmen aufweisen, durch den die Maske seitlich verspannt wird, um der dünnen Folie, aus der die Maske üblicherweise gefertigt ist, eine gewisse Stabilität zu verleihen. Obwohl mit einer derartigen magnetischen Anziehung der Maske gegen das Substrat eine vollflächige Anlage der Maske an dem Substrat und somit Blasenfreiheit und scharfe Beschichtungskanten erzielt werden, ist eine derartige Anordnung für die schnelle und präzise Handhabbarkeit in Bezug auf Maskenwechsel, insbesondere unter Vakuumbedingungen, nicht optimal. Außerdem dienen die Magnete lediglich zum vollflächigen, blasenfeien Anlegen der Maske an das Substrat, jedoch nicht für Halterung in einem dynamischen System, in dem das Substrat auf dem Substratträger mit der Maske durch den Beschichtungsbereich bewegt wird.

Es ist deshalb Aufgabe der vorliegenden Erfindung, eine Maskenhalterung für dynamische Vakuumbeschichtungsprozesse insbesondere bei der In-Line-Herstellung von OLED-Bildschirmen oder -Displays bereit zu stellen, bei der die Nachteile des Standes der Technik vermieden und insbesondere eine präzise, schnelle und einfache Möglichkeit des Maskenwechsels sowie eine sichere und zuverlässige Anordnung der Maske an dem während der Beschichtung bewegten (dynamischen) Substrat gewährleistet ist. Insbesondere sollen die entsprechenden Vorrichtungen für den Maskenwechsel einfach herstellbar und einfach zu bedienen sein.

Die vorliegende Erfindung zeichnet sich dadurch aus, dass der Substratträger ein oder mehrere Magnete umfasst und dadurch in der Lage ist, die Maske während des Transports durch die Beschichtungsanlage unmittelbar zu halten, so dass die Maske direkt auf dem zwischen Substratträger und Maske angeordnetem Substrat oder in Bezug zu diesem Substrat gehalten wird.

Durch diese Anordnung wird zum einen das Substrat geschont, da die Haltefunktion für die Maske unmittelbar auf den Substratträger übergeht. Zum anderen wird durch die magnetische Halterung eine einfache Handhabung sowie eine sichere Halterung der Maske während des Transports durch die Vakuumbeschichtungsanlage gewährleistet. Durch die vorbestimmte Anordnung der Magnete auf dem Substratträger sowie durch die Verwendung von mehreren örtlich begrenzten Magneten gegenüber großflächigen Magneten ist auch ein einfaches Zusammenwirken mit einer entsprechenden Handhabungseinrichtung, die vorzugsweise schaltbare Elektromagnete aufweisen kann, gewährleistet.

Die Magnete der Maskenhalterung auf dem Substratträger können sowohl Permanentmagnete als auch Elektromagnete sein.

Die Magnete sind vorzugsweise äquidistant beabstandet zueinander umlaufend um den Substrataufnahmebereich an dem Substratträger vorgesehen, wobei sie beispielsweise eine Ringform, eine Rechteckform oder eine mehreckige geschlossene Bandform bilden können. Durch eine derartige Anordnung wird insbesondere eine gleichmäßige Halterung der Maske gewährleistet. Vorzugsweise sind die Magnete an der Rückseite des Substratträgers, also gegenüberliegend dem Substrat über eine Maskenhalteplatte oder einen entsprechenden Rahmen gehalten, welche(r) insbesondere lösbar an der Substrataufnahmeplatte angeordnet ist. Gemäß einer bevorzugten Ausführungsform sind zwischen Substrataufnahmeplatte und Maskenhalteplatte Distanzstücke vorgesehen, so dass die Magnete zwischen Substrataufnahmeplatte und Maskenhalteplatte aufgenommen bzw. gehalten sind.

Gemäß der Erfindung ist die Maske entsprechend der Anordnung der Magnete auf dem Substratträger so ausgebildet, dass sie zumindest einen magnetischen Rand oder Rahmen aufweist, wobei man von Rand dann spricht, wenn die Maske insgesamt einstückig ausgebildet, während vom Rahmen die Rede ist, wenn die Maske insgesamt mehrteilig ist und insbesondere Rahmen und Maske aus zwei unterschiedlichen Teilen gebildet sind. Auf diese Weise ist es möglich, dass auch unmagnetische Maskenmaterialien eingesetzt werden können, die dann in entsprechende magnetische Rahmenanordnungen eingebracht werden.

Bei der Verwendung eines Rahmens ist es zudem möglich, die dünnen folienartigen Masken auch entlang der Folienebene zu spannen, so dass sie senkrecht zur Folienebene eine höhere Stabilität aufweisen.

Ferner ermöglicht die Verwendung eines Rahmens bzw. die Anordnung der Haltemagnete in Bezug zum Rand der Maske deren stabile Befestigung mit entsprechend hohen Magnetkräften.

Zusätzlich zur magnetischen Halterung können auch weitere Halterungsmöglichkeiten ergänzend vorgesehen werden, bei denen beispielsweise die Magnete des Substratträgers formschlüssig in entsprechende Aussparungen des Rahmens der Maske eingreifen können.

Die Auflage- bzw. Anlagefläche zwischen Substratträger bzw. Substrat und Maske bzw. Rahmen ist vorzugsweise so gestaltet, dass die Maske vollflächig am Substrat anliegt.

Zusätzlich können noch weitere Magnete im eigentlichen Maskenbereich im oder am Substratträger vorgesehen sein, um insbesondere bei magnetischen Masken ein vollflächiges Anpressen der Maske an das Substrat zu gewährleisten.

Weitere Vorteile, Kennzeichen und Merkmale der vorliegenden Erfindung werden bei der nachfolgenden detaillierten Beschreibung eines Ausführungsbeispiels anhand der beigefügten Zeichnungen deutlich. Die Zeichnungen zeigen hierbei rein schematisch in
- Fig. 1: eine Seitenansicht einer Maskenaufbringungsstation, mit der Maske in abgehobenem Zustand;
- Fig. 2: die Maskenaufbringungsstation aus Fig. 1 mit am Substrat angeordneter Maske;
- Fig. 3: die Maskenaufbringungsstation der Fig. 1 und Fig. 2 mit auf dem Substrat abgesetzter Maske; und in
- Fig. 4: eine Draufsicht auf eine Maske mit Rahmen.

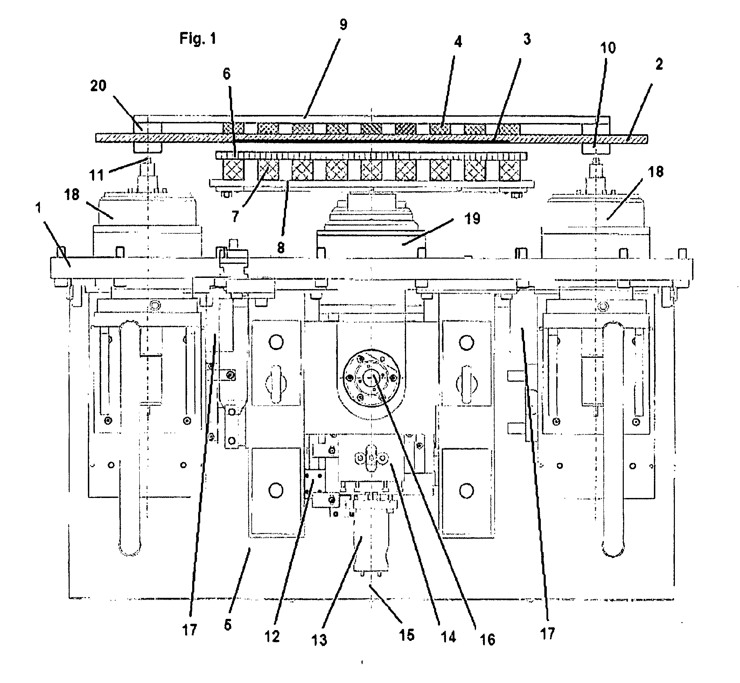

Die Fig. 1 zeigt in einer Seitenansicht und teilweisen Querschnittsansicht eine Maskenaufbringungsstation für eine Vakuumkammer einer Vakuumbeschichtungsanlage, insbesondere für die kontinuierliche (In-Line-) Beschichtung von transparenten Substraten mit organischen, elektrolumineszierenden Materialien für die Herstellung von OLED-Displays bzw. -Bildschirmen oder -Anzeigen.

Die Fig. 1 zeigt einen Schnitt durch eine Kammerwand oder eine Montageplatte 1, die in die Kammerwand einsetzbar ist, wobei in der Vakuumkammer, also oberhalb der Montageplatte 1 der Fig. 1, ein Substratträger 2 mit einem darauf angeordneten Substrat 3 dargestellt ist, der durch nicht dargestellte Transport- bzw. Fördereinrichtungen durch die Vakuumkammer transportiert werden kann.

In dem in Fig. 1 dargestellten Zustand befindet sich das Substrat oberhalb einer Maskenaufbringungsstation mit einer Maskenpositioniereinrichtung 5, mit deren Hilfe die Maske 6 auf dem Substrat 3 angeordnet und ausgerichtet werden kann.

Die Maskenpositioniereinrichtung 5 weist eine Vielzahl von Elektromagneten 7 auf, die umlaufend um eine Halteplatte oder -rahmen 8 angeordnet sind. Der Halterahmen 8 ist wiederum über eine vakuumdichte Führung 19 mit verschiedenen Antrieben 12, 13, 14 und 16 verbunden, die eine Bewegung der Halteplatte bzw. des -rahmens 8 bezüglich des Substratträgers 2 bzw. des Substrats 3 ermöglichen. Dabei erlaubt der Horizontalantrieb 12 eine Bewegung in horizontaler Richtung, der Vertikalantrieb 16 in vertikaler Richtung, also aus der Bildebene heraus, und der Axialantrieb 13 in axialer Richtung, also in Richtung der Achse 15. Zusätzlich ist ein Drehantrieb 14 vorgesehen, der eine Drehung der Halteplatte 8 um die Achse 15 erlaubt. Auf Grund der Antriebe 12, 13, 14 und 16 kann somit die Halteplatte 8 in jede beliebige Position bezüglich des Substratträgers 2 gebracht werden.

Neben der Maskenpositioniereinrichtung 5 ist eine zweite Bewegungseinrichtung in Form von vorzugsweise mehreren, im Ausführungsbeispiel insgesamt vier, zum Ergreifen der Ecken des rechteckigen Substratträgers in einem Viereck angeordneten Hubeinrichtungen 18 vorgesehen. Die Hubeinrichtungen 18 weisen an ihren Enden jeweils Kopplungselemente 11 auf, die mit Substratträgerkopplungen 10 zusammen wirken, so dass der Substratträger 2 mit den Hubeinrichtungen 18 so verbunden werden kann, dass diese den Substratträger 2 bewegen können.

Der Hubmechanismus bzw. -antrieb 18 kann einen hydraulischen oder pneumatischen Hubzylinder oder, wie im bevorzugten Ausführungsbeispiel, auch einen Spindelantrieb umfassen, der durch eine besonders gleichmäßige, exakte und ruckfreie Bewegung ausgezeichnet ist. In gleicher Weise kann auch der Axialantrieb 13 oder die anderen Antriebe ausgebildet sein.

Neben den Hubantrieben 18 und der Maskenpositioniereinrichtung 5 sind an der Montageplatte 1 noch zusätzlich CCD-Kameras 17, vorzugsweise mindestens zwei Kameras vorgesehen, die über jeweils ein Fensterelement die Positionierung der Maske 6 auf dem Substrat 3 überwachen können. Die CCD-Kameras bilden eine Überwachungseinheit, die die exakte Positionierung der Maske zum Substrat überprüfen. Bei einer Fehlstellung wird eine Steuerungseinheit (nicht gezeigt) aktiviert, die die Bewegung der Maskenpositioniereinrichtung 5 steuert. Durch die Antriebe 12, 14 und 16 kann die Maske 6 exakt positioniert werden, da damit eine Ausrichtung des Halterahmens 8 in zwei zueinander senkrechten Richtungen sowie eine Rotation möglich ist. Darüber hinaus ermöglicht der Axialantrieb 13 eine Positionsanpassung bezüglich des Abstands der Maske 6 zum Substrat 3. Insgesamt ergibt sich somit mit der Maskenpositioniereinrichtung 5 die Möglichkeit einer exakten Positionierung der Maske in drei unabhängige Raumrichtungen.

Der Substratträger 2 umfasst umlaufend um den Bereich, in dem das Substrat 3 zu liegen kommt, eine Vielzahl von Magneten 4, die in ihrer Lage mit den Elektromagneten 7 korrespondieren. Dies bedeutet, dass bei Einhaltung der vorgesehen Substrat- und Maskenpositionen die Elektromagnete 7 und die Magnete 4 des Substratträgers 2 bei der Übergabe der Maske an das Substrat 3 einander genau gegenüber liegen bzw. ihre Längsachsen auf einer Achse angeordnet sind. Die Magnete 4 können sowohl Permanentmagnete als auch Elektromagnete sein. Die Magnete 4 sind an der Rückseite des Substratträgers 2 an einem Maskenhalterahmen 9 angeordnet, der wiederum über Abstandshalter 20 an der Substrataufnahmeplatte des Substratträgers 2 angeordnet ist. Der Maskenhalterahmen 9 kann hierbei in jeder geeigneten Weise an der Substrathalteplatte des Substratträgers 2, insbesondere lösbar befestigt sein.

Der Maskenhalterahmen 9 kann sowohl als ringförmiger Rahmen als auch als durchgehende Platte ausgebildet sein. Insbesondere dient der Maskenhalterahmen auch als Magnetjoch für die daran angeordneten Magnete 4.

Die ring- oder rahmenartige Anordnung der Magnete 4,7 um oder entlang des Randes des Aufnahmebereichs für das Substrat 3 bewirkt, dass eine gleichmäßige und für die dynamische Beschichtung ausreichend feste Halterung der Maske 6 mit für die Handhabung ausreichend großen Magnetkräften ohne Beschädigung der dünnen, folienartigen Masken erfolgt.

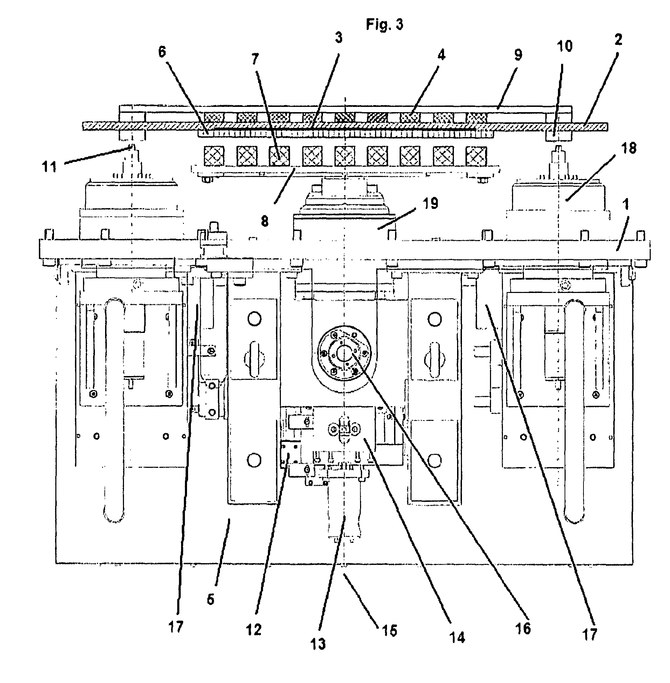

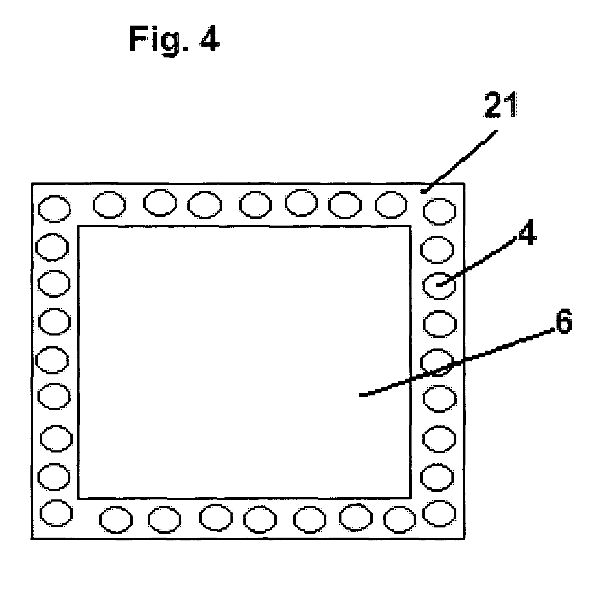

Die Übergabe der Maske an das Substrat erfolgt gemäß der Darstellungen der Figuren 1 bis 3 in der Weise, dass die Maske 6 zunächst von einer Maskenzuführung an die Maskenpositionieranordnung 5 übergeben wird, wobei die Maske 6 einen umlaufenden magnetischen Rahmen oder Rand 21 (siehe Fig. 4) aufweist, der mit den umlaufenden bzw. ringförmig angeordneten Elektromagneten an dem Halterahmen 8 der Maskenpositioniereinrichtung 5 korrespondiert, so dass die Maske 6 über ihren Rahmen 21 oder Rand durch die Elektromagnete 7 der Halteplatte 8 bei entsprechender Aktivierung der Elektromagnete 7 gehalten werden kann.

Sobald das Substrat 3, auf dem die Maske 6 angeordnet werden soll, in einer entsprechend vordefinierten Position gegenüber der Maskenpositioniereinrichtung 5 angeordnet ist, wird über die Antriebe 12,14 und 16 unter Zuhilfenahme der CCD-Kameras 17 die exakte laterale Ausrichtung der Maske 6 zum Substrat 3, also die Ausrichtung in Bezug auf die x-/y-Koordinaten, eingestellt.

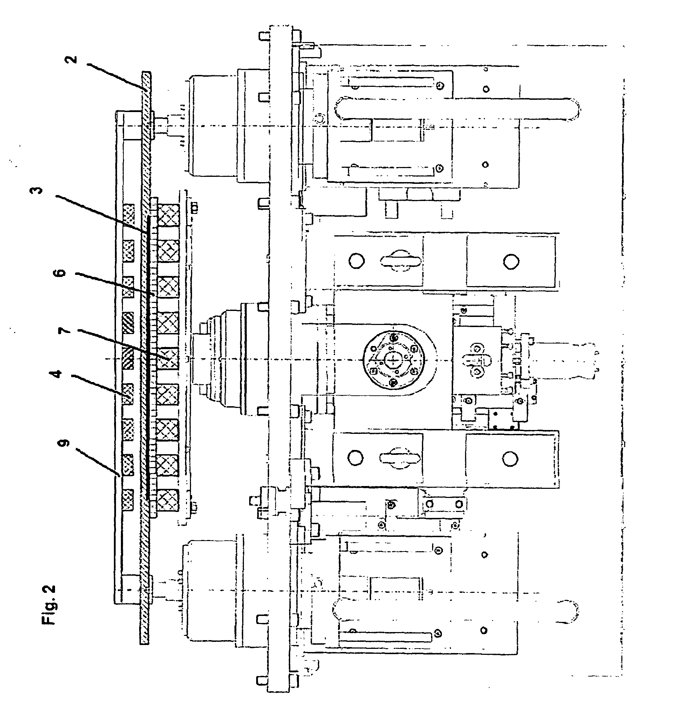

Wenn die Maske 6 in der richtigen Lage oberhalb des Substrats 3 ausgerichtet ist, also in der Projektion Deckungsgleichheit erzielt ist, wird der Substratträger 2 mit dem Substrat 3 durch die Kopplungselemente 11 der Hubeinrichtungen 18 an der Substratträgerkopplung 10 ergriffen und, wie in Fig. 2 dargestellt, mittels der Hubeinrichtungen 18 von hinten an die Maske 6 heran gefahren, so dass der magnetische Rahmen oder Rand der Maske 6 über den Magneten 4 des Substratträgers sowie die Maske 6 über dem Substrat 3 zu liegen kommen. Zusätzlich oder alternativ kann die Bewegung senkrecht zur Substrat- oder Maskenebene auch vom Axialantrieb 13 bewirkt werden.

Danach werden die Elektromagnete 7 deaktiviert bzw. ausgeschaltet und das Substrat 3 mittels der Hubantriebe 18 nach oben weggefahren.

Das Substrat 3 steht dann mit der Maske 6 für den Weitertransport durch die Vakuumbeschichtungsanlage bereit, wobei die Maske 6 über den Rahmen 21 bzw. Rand auf dem Substrat 3 durch die Magnete 4 des Substratträgers 2 gehalten ist.

Dies wird insbesondere in der Draufsicht der Fig. 4 deutlich, welche die Maske 6 und den Rahmen oder Rand 21 der Maske 6 sowie die Magnete 4 zeigt, die sich unterhalb des Rahmens oder Randes 21 auf dem darunter angeordneten Substratträger 2 (nicht gezeigt) befinden. Die gewählte Anordnung der Maskenhalterung über Magnete 4 am Substratträger, insbesondere in einer ring- oder rahmenförmigen Anordnung um oder entlang des Randes des Substrats und das entsprechende Vorsehen eines Rahmens bzw. Randes an der Maske zum Zusammenwirken mit den Magneten, ermöglichen eine einfache Handhabung der Maske, eine sichere Halterung der Maske am Substrat bzw. Substratträger während der dynamischen Beschichtung sowie eine wesentliche Reduzierung der entstehenden Partikel bei der Handhabung der Maske, also dem Auf- und Absetzen der Maske. Ferner ist eine kostengünstige Konstruktion und Ausführung des Gesamtssystems ermöglicht.

Durch die Verwendung von Elektromagneten zum Aufnehmen und Absetzen bzw. Halten der Maske an ihrem Rahmen bzw. Rand in der Positioniereinrichtung ist eine einfache Übergabe gewährleistet, wobei insbesondere bei Verwendung eines Spindelantriebs zur Höhenverstellung der Positioniereinrichtung und/oder der Hubeinrichtungen für den Substratträger eine besonders gleichmäßige und ruckfreie Bewegung und Übergabe erzielt werden kann. Die Maske 6 und der Rahmen 21 können sowohl einstückig als auch mehrteilig ausgebildet sein, wobei bei mehrteiligen Ausführungen von einem Rahmen gesprochen wird, während bei einstückiger Ausführung von einem Rand die Rede ist.

Obwohl hier nur die Anordnung der Maske auf dem Substrat beschrieben ist, ist selbstverständlich auch die Abnahme der Maske vom Substrat mit der gleichen Vorrichtung in umgekehrter Weise möglich. Lediglich die Ausrichtung der Maske kann entsprechend entfallen.

### Bezugszeichenliste:

- 1: Kammerwand
- 2: Substratträger
- 3: Substrat
- 4: Magnete
- 5: Maskenpositioniereinrichtung
- 6: Maske
- 7: Elektromagnete
- 8: Halteplatte bzw. -rahmen
- 9: Maskenhalterahmen
- 10: Substratträgerkopplung
- 11: Greifeinrichtung
- 12: Horizontalantrieb
- 13: Axialantrieb
- 14: Drehantrieb
- 15: Positionierachse
- 16: Vertikalantrieb
- 17: Kamera
- 18: Hubeinrichtung
- 19: Führung
- 20: Abstandshalter
- 21: Maskenrahmen

## Patentansprüche

1. Maskenhalterung für großflächige Substrate, insbesondere für die Mikrostrukturierung von organischen elektrolumineszierenden Materialien (OLED) zur Herstellung von OLED-Bildschirmen, -Displays und dgl. mittels Vakuumbeschichtungsverfahren, mit einem Substratträger (2) zur Aufnahme des Substrats (3) während des oder der Beschichtungsprozesse,
**dadurch gekennzeichnet, dass**
der Substratträger (2) an seiner Rückseite gegenüberliegend dem Substrataufnahmebereich ein oder mehrere Magnete (4) umfasst, die beabstandet zueinander umlaufend um oder entlang des Randes des Substrataufnahmebereichs an dem Substratträger vorgesehen sind, und die Maske (6) einen Rahmen (21) aus magnetischem Material aufweist, so dass der Rahmen der Maske mittels des oder der Magnete des Substratträgers in Bezug auf das zu beschichtende Substrat gehalten ist.

2. Maskenhalterung nach Anspruch 1,
**dadurch gekennzeichnet, dass**
die Magnete (4) Permanentmagnete oder Elektromagnete sind.

3. Maskenhalterung nach Anspruch 1 oder 2,
**dadurch gekennzeichnet, dass**
die Magnete (4) äquidistant beabstandet zueinander umlaufend um oder entlang des Randes des Substrataufnahmebereichs an dem Substratträger vorgesehen sind.

4. Maskenhalterung nach einem der vorhergehenden Ansprüche,
**dadurch gekennzeichnet, dass**
das Substrat (3) zwischen Maske (6) und Substratträger (2) angeordnet ist.

5. Maskenhalterung nach einem der vorhergehenden Ansprüche,
**dadurch gekennzeichnet, dass**
der Rahmen (21) und die Maske (6) einstückig oder mehrteilig, oder als zwei separate Teile ausgebildet sind.

6. Maskenhalterung nach einem der vorhergehenden Ansprüche,
**dadurch gekennzeichnet, dass**
der Substratträger (2) einen Maskenhalterahmen (9) zur Aufnahme der Magnete (4) des Substratträgers (2) aufweist.

7. Maskenhalterung nach Anspruch 6,
**dadurch gekennzeichnet, dass**
der Maskenhalterahmen (9) über Abstandshalter (20) so lösbar an dem Substratträger (2) angeordnet ist, dass die Magnete (4) zwischen Maskenhalterahmen (9) und Rückseite der Substrataufnahmeplatte des Substratträgers (2) angeordnet sind.

8. Maskenhalterung nach einem der vorhergehenden Ansprüche,
**dadurch gekennzeichnet, dass**
die Auflageebene des Rahmens (21) auf dem Substratträger, unter Berücksichtigung der Lage der Maske (6) in Bezug auf den Rahmen (21) so abgestimmt ist, dass die Maske (6) vollflächig am Substrat (3) anliegt.

9. Maskenhalterung nach einem der vorhergehenden Ansprüche,
**dadurch gekennzeichnet, dass**
der Rahmen (21) ringförmig, rechteckig oder mehreckig ist und/oder die Maske (6) vollständig umschließt.

10. Maskenhalterung nach einem der vorhergehenden Ansprüche,
**dadurch gekennzeichnet, dass**
zusätzliche Magnete am Substratträger (2) zum vollflächigen Anpressen der Maske (6) an das Substrat vorgesehen sind.

## Claims

1. Mask holder for large-surface substrates, especially for the microstructuring of organic electroluminescent materials (OLED) for the production of OLED screens, displays and the like by means of vacuum-coating processes, with a substrate carrier (2) for receiving the substrate (3) during the coating process(es),
**characterised by** the fact that
the rear side of the substrate carrier (2) comprises one or more magnets (4) opposite the substrate-receiver area that are spaced apart from each other peripherally or along the edge of the substrate-receiver area at the substrate carrier, and the mask (6) features a frame (21) of magnetic material, such that the frame of the mask is held by means of the magnet(s) of the substrate carrier relative to the substrate to be coated.

2. Mask holder of claim 1
**characterised by** the fact that
the magnets (4) are permanent magnets or electromagnets.

3. Mask holder of claim 1 or 2
**characterised by** the fact
the magnets (4) are spaced equidistantly from each other peripherally or along the edge of the substrate-receiver area at the substrate carrier.

4. Mask holder in accordance with any of the previous claims
**characterised by the fact that**
the substrate (3) is arranged between the mask (6) and the substrate carrier (2).

5. Mask holder in accordance with any of the previous claims
**characterised by the fact that**
the frame (21) and the mask (6) are formed in one piece or multiple pieces or as two separate pieces.

6. Mask holder in accordance with any of the previous claims
**characterised by** the fact that
the substrate carrier (2) features a mask-holder frame (9) for receiving the magnets (4) of the substrate carrier (2).

7. Mask holder of claim 6
**characterised by** the fact that
the mask-holder frame (9) is detachably arranged at the substrate carrier (2) via spacers (20), such that the magnets (4) are arranged between the mask-holder frame (9) and the rear side of the substrate-receiver plate of the substrate carrier (2).

8. Mask holder in accordance with any of the previous claims
**characterised by** the fact that
the placement plane of the frame (21) on the substrate carrier, with allowance for the position of the mask (6) relative to the frame (21), is aligned such that the mask (6) makes full-surface contact at the substrate (3).

9. Method in accordance with any of the previous claims
**characterised by** the fact that
the frame (21) is annular, rectangular or polygonal and/or completely encloses the mask (6).

10. Mask holder in accordance with any of the previous claims
**characterised by the fact that**
additional magnets are provided at the substrate carrier (2) for the purpose of pressing the full surface of the mask (6) against the substrate.

## Revendications

1. Support de masque pour des substrats à grande surface, en particulier pour la micro-structuration de matériaux organiques électroluminescents (OLED) pour la fabrication d'écrans OLED, d'affichages OLED et semblable au moyen de procédés de dépôt sous vide, comprenant un porte-substrat (2) destiné à recevoir le substrat (3) durant le ou les processus de dépôt, **caractérisé par le fait que** ledit porte-substrat (2) comprend - sur sa face arrière, en vis-à-vis de la zone de réception du substrat - un ou plusieurs aimant(s) (4) qui sont prévus à distance les uns des autres tout autour ou le long du bord de la zone de réception du substrat sur le porte-substrat, et que le masque (6) présente un cadre (21) en matériau magnétique de sorte que le cadre du masque est maintenu par rapport au substrat à revêtir au moyen du ou des aimant(s) du porte-substrat.

2. Support de masque selon la revendication 1, **caractérisé par le fait que** lesdits aimants (4) sont des aimants permanents ou des électro-aimants.

3. Support de masque selon la revendication 1 ou 2, **caractérisé par le fait que** les aimants (4) sont prévus à équidistance les uns des autres tout autour ou le long du bord de la zone de réception du substrat sur le porte-substrat.

4. Support de masque selon l'une des revendications précédentes, **caractérisé par le fait que** ledit substrat (3) est disposé entre le masque (6) et le porte-substrat (2).

5. Support de masque selon l'une des revendications précédentes, **caractérisé par le fait que** le cadre (21) et le masque (6) sont réalisés en une seule pièce ou en plusieurs parties ou comme deux parties séparées.

6. Support de masque selon l'une des revendications précédentes, **caractérisé par le fait que** le porte-substrat (2) présente un cadre de support de masque (9) pour recevoir les aimants (4) du porte-substrat (2).

7. Support de masque selon la revendication 6, **caractérisé par le fait que** le cadre de support de masque (9) est disposé de manière amovible par l'intermédiaire d'écarteurs (20) sur le porte-substrat (2) de façon à ce que les aimants (4) soient disposés entre le cadre de support de masque (9) et la face arrière de la plaque de réception de substrat du porte-substrat (2).

8. Support de masque selon l'une des revendications précédentes, **caractérisé par le fait que** le plan d'appui du cadre (21) sur le porte-substrat est accordé, en considération de la position du masque (6) par rapport au cadre (21), de telle manière que ledit masque (6) s'appuie sur toute la surface sur le substrat (3).

9. Support de masque selon l'une des revendications précédentes, **caractérisé par le fait que** ledit cadre (21) est annulaire, rectangulaire ou polygonal et/ou entoure le masque (6) complètement.

10. Support de masque selon l'une des revendications précédentes, **caractérisé par le fait que** l'on prévoit des aimants supplémentaires sur le porte-substrat (2) pour presser le masque (6) sur toute la surface contre le substrat.
